(19) **Europäisches Patentamt / European Patent Office / Office européen des brevets**

(11) **EP 4 383 566 A1**

(12) # DEMANDE DE BREVET EUROPEEN

(43) Date de publication:
**12.06.2024 Bulletin 2024/24**

(21) Numéro de dépôt: **23209358.3**

(22) Date de dépôt: **13.11.2023**

(51) Classification Internationale des Brevets (IPC):
**H03H 17/02** (2006.01)    **H03H 17/06** (2006.01)
**H03H 17/00** (2006.01)

(52) Classification Coopérative des Brevets (CPC):
**H03H 17/0229; H03H 17/06;** H03H 17/0294;
H03H 2017/0081; H03H 2218/02

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **28.11.2022 FR 2212378**

(71) Demandeur: **STMICROELECTRONICS SA**
**92120 Montrouge (FR)**

(72) Inventeurs:
• **ANDRE, Eric**
**38570 HURTIÈRES (FR)**
• **VOGT, Lionel**
**73110 LA ROCHETTE (FR)**

(74) Mandataire: **Cabinet Beaumont**
**4, Place Robert Schuman**
**B.P. 1529**
**38025 Grenoble Cedex 1 (FR)**

(54) **DISPOSITIF ET MÉTHODE DE FILTRAGE**

(57) La présente description concerne un émetteur radiofréquence comprenant au moins un circuit de filtrage (400) comprenant : un registre à décalage (402) série/parallèle comprenant une entrée binaire (In) et N sorties binaires Oi, avec N un entier supérieur ou égal à OSR, OSR un entier supérieur ou égal à 2, et i un indice entier allant de 0 à N-1, le registre recevant un signal binaire de donnée (DATA) à une fréquence Fdata sur son entrée (In) et mettant en œuvre des décalages sur ses sorties Oi à une fréquence égale à Fdata*OSR ; un circuit (404) défini par N coefficients Ci fournissant, pour chaque coefficient Ci non nul, un signal SIGi déterminé par le coefficient Ci et par la sortie Oi correspondante ; et un circuit sommateur (408, 502) fournissant une sortie (OUT) égale à la somme des signaux SIGi.

Fig. 4

EP 4 383 566 A1

**Description**

Domaine technique

La présente description concerne de façon générale les dispositifs, les circuits et les méthodes de filtrage d'un signal.

Technique antérieure

On connaît des dispositifs ou circuits électroniques configurés pour émettre un signal sans fil, par exemple un signal radiofréquence, c'est à dire un signal ayant une fréquence porteuse comprise dans la gamme des radiofréquences allant, par exemple, de 1 GHz à 120 GHz.

En fonction d'une application visée, par exemple définie par un standard ou une norme, toute la puissance du signal émis par ces dispositifs doit être comprise dans une première plage donnée de fréquences et/ou au moins un certain pourcentage de la puissance du signal émis par ces dispositifs doit être comprise dans une deuxième plage donnée de fréquences, la deuxième plage étant plus étroite que la première.

Le respect des conditions d'émission en ce qui concerne la puissance du signal émis nécessite de mettre en oeuvre un filtre qui pose de nombreux problèmes, par exemple quand le signal est émis dans la bande des 60 GHz.

Résumé de l'invention

Il existe un besoin de pallier tout ou partie des inconvénients des circuits, dispositifs et méthodes de filtrage connus, par exemple lorsque le filtrage est mis en oeuvre pour mettre en forme un signal radiofréquence à émettre, par exemple dans la bande des 60 GHz.

Un mode de réalisation pallie tout ou partie des inconvénients des circuits, dispositifs et méthodes de filtrage connus, par exemple lorsque le filtrage est mis en oeuvre pour mettre en forme un signal radiofréquence à émettre, par exemple dans la bande des 60 GHz.

Un mode de réalisation prévoit un émetteur radiofréquence comprenant au moins un circuit de filtrage, ledit au moins un circuit de filtrage comprenant :

un registre à décalage série/parallèle comprenant une entrée binaire et N sorties binaires Oi, avec N un entier supérieur ou égal à OSR, OSR un entier supérieur ou égal à 2, et i un indice entier allant de 0 à N-1, le registre à décalage étant configuré pour recevoir un signal binaire de donnée à une fréquence Fdata sur son entrée et pour mettre en oeuvre des décalages sur ses sorties Oi à une fréquence égale à Fdata*OSR ;

un premier circuit défini par N coefficients Ci et configuré pour fournir, pour chaque coefficient Ci non nul, un signal SIGi analogique déterminé par ledit coefficient Ci et par un état binaire de la sortie Oi correspondante ; et

un circuit sommateur configuré pour fournir un signal analogique de sortie dudit circuit de filtrage égal à la somme des signaux analogiques SIGi.

Un autre mode de réalisation prévoit un procédé mis en oeuvre dans un émetteur radiofréquence comprenant au moins un circuit de filtrage, le procédé comprenant :

recevoir un signal binaire de donnée à une fréquence Fdata sur une entrée binaire d'un registre à décalage série/parallèle dudit au moins un circuit de filtrage, le registre à décalage comprenant N sorties binaires Oi, avec N un entier supérieur ou égal à OSR, OSR un entier supérieur ou égal à 2 et i un indice entier allant de 0 à N-1 ; mettre en oeuvre avec le registre à décalage des décalages de ses sorties Oi à une fréquence Fdata*OSR ;

avec un premier circuit dudit au moins un circuit de filtrage, ledit premier circuit étant défini par N coefficients Ci, fournir, pour chaque coefficient Ci non nul, un signal SIGi déterminé par le coefficient Ci et un état binaire de la sortie Oi correspondante ; et

fournir, avec un circuit sommateur dudit au moins un circuit de filtrage, un signal analogique de sortie dudit circuit de filtrage égal à la somme des signaux analogiques SIGi.

Selon un mode de réalisation, les coefficients Ci sont déterminés par une réponse impulsionnelle h(t) d'un filtre d'interpolation, de préférence de type à cosinus surélevés.

Selon un mode de réalisation :

- pour i allant de 0 à N-1, chaque coefficient Ci est égal à un coefficient Dp d'indice p entier égal à i+min, min étant un entier positif ou nul ;

- chaque coefficient Dp, avec p indice entier allant de 0 à P-1 et P un entier impair strictement supérieur à N, est calculé de manière récursive avec la formule suivante : $Dp = Bp - \sum_{j=p-OSR+1}^{j=p-1} Dj$ , où j est un indice entier, Dj est nul si j est strictement négatif et est égal au coefficient Dp avec p = j sinon, et Bp est un coefficient d'indice p ; et

- chaque coefficient Bp, avec p l'indice entier allant de 0 à P-1, est déterminé par la formule suivante : Bp = h((2*p-P+1)/(2*OSR)) où h(t) est normalisée et centrée sur t=0.

Selon un mode de réalisation le registre à décalage dudit au moins un circuit de filtrage comprend N verrous synchrones commandés par un signal d'horloge à une fréquence égale à Fdata*OSR/2, les N verrous étant connectés en série en alternant les verrous actifs sur un premier niveau du signal d'horloge et les verrous actifs sur un deuxième niveau du signal d'horloge, les sorties Oi correspondant aux sorties des N verrous.

Selon un mode de réalisation, le registre à décalage dudit au moins un circuit de filtrage comprend en outre une bascule synchrone de type D ayant une entrée de donnée couplée, de préférence connectée, à l'entrée série dudit registre à décalage, une entrée de synchronisation configurée pour recevoir le signal d'horloge, et une sortie connectée à une entrée de donnée du premier desdits N verrous connectés en série.

Selon un mode de réalisation, le registre à décalage dudit au moins un circuit de filtrage comprend N bascules synchrones de type D commandées par un signal d'horloge à une fréquence égale à Fdata*OSR, les N bascules étant connectées en série, et les sorties Oi correspondant aux sorties des N bascules.

Selon un mode de réalisation, le registre à décalage dudit au moins un circuit de filtrage comprend N bascules synchrones de type D commandées par un signal d'horloge à une fréquence égale à Fdata*OSR/2, les N bascules synchrones étant connectées en série en alternant les bascules actives sur les fronts montants du signal d'horloge et les bascules actives sur les fronts descendants du signal d'horloge, et les sorties Oi correspondant aux sorties des N bascules.

Selon un mode de réalisation, pour chaque coefficient Ci non nul :

le premier circuit dudit au moins un circuit de filtrage comprend un nombre Ki de circuits élémentaires identiques ayant chacun une sortie configurée pour fournir :

- un signal analogique S0 lorsque la sortie correspondante Oi est dans un premier état binaire et que le coefficient Ci est positif,
- un signal S1 complémentaire du signal S0 lorsque la sortie correspondante Oi est dans un deuxième état binaire et que le coefficient Ci est positif,
- le signal S1 lorsque la sortie correspondante Oi est dans le premier état binaire et que le coefficient Ci est négatif, et
- le signal S0 lorsque la sortie correspondante Oi est dans le deuxième état binaire et que le coefficient Ci est négatif ; et

le nombre Ki est égal la valeur absolue de l'arrondi à une valeur entière du produit du coefficient Ci par un entier INT identique pour tous les coefficients Ci.

Selon un mode de réalisation, le premier circuit dudit au moins un circuit de filtrage comprend une pluralité de circuits élémentaires identiques pour chaque coefficient Ci, le premier circuit comprenant en outre un circuit de sélection configuré pour sélectionner, pour chaque coefficient Ci, Ki circuits élémentaires parmi ladite pluralité de circuits élémentaires et pour éteindre les circuits élémentaires non sélectionnés, Ki étant nul pour les coefficients Ci nuls.

Selon un mode de réalisation, chaque circuit élémentaire reçoit un même signal périodique et est configuré pour que le signal S0 soit en phase avec ce signal périodique et à la même fréquence que ce signal périodique.

Selon un mode de réalisation :

la sortie de chaque circuit élémentaire comprend un premier noeud de sortie et un deuxième noeud de sortie ;
chaque circuit élémentaire comprend :

- un premier transistor MOS couplant un noeud de référence à un premier noeud interne,
- un deuxième transistor MOS couplant le noeud de référence à un deuxième noeud interne,
- un troisième transistor MOS couplant le premier noeud interne au premier noeud de sortie et ayant une grille configurée pour recevoir ledit signal périodique,

- un quatrième transistor MOS couplant le premier noeud interne au deuxième noeud de sortie et ayant une grille configurée pour recevoir un signal en opposition de phase avec le signal périodique,
- un cinquième transistor MOS couplant le deuxième noeud interne au premier noeud de sortie et ayant une grille configurée pour recevoir le signal en opposition de phase, et
- un sixième transistor MOS couplant le deuxième noeud interne au deuxième noeud de sortie et ayant une grille configurée pour recevoir le signal périodique ; et

pour chaque coefficient Ci non nul et pour chacun des Ki circuits élémentaires de ce coefficient Ci, les premier et deuxième transistors sont commandés à partir de la sortie correspondante Oi, en en opposition de phase l'un par rapport à l'autre.

Selon un mode de réalisation :

l'émetteur comprend deux circuits de filtrage configurés pour fournir leurs signaux de sortie à un même noeud couplé à une antenne de l'émetteur ;
l'entrée du registre à décalage d'un premier des deux circuits de filtrage reçoit un premier signal binaire de donnée à la fréquence Fdata ; et
l'entrée du registre à décalage d'un deuxième des deux circuits reçoit un deuxième signal binaire de donnée à la fréquence Fdata.

Selon un mode de réalisation :

l'émetteur comprend au moins un oscillateur local configuré pour fournir un premier signal périodique et un deuxième signal périodique en quadrature avec le premier signal périodique ;
ledit même signal périodique reçu par les circuits élémentaires du premier circuit de filtrage est le premier signal périodique ; et
ledit même signal périodique reçu par les circuits élémentaires du deuxième circuit de filtrage est le deuxième signal périodique.

Selon un mode de réalisation, l'émetteur est configuré pour émettre dans la bande des 60 GHz.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre un exemple de répartition spectrale de la puissance d'un signal radiofréquence émis, et la réponse spectrale d'un exemple de filtre ;

la figure 2 illustre un exemple de répartition spectrale de la puissance d'un signal radiofréquence émis, et la réponse spectrale d'un autre exemple de filtre ;

la figure 3 illustre, par deux vues A et B très schématiques, un exemple de mise en oeuvre d'un filtre ;

la figure 4 illustre, par deux vues A et B très schématiques, un mode de réalisation d'un filtre ;

la figure 5 représente sous la forme de blocs un exemple plus détaillé d'un mode de réalisation du filtre de la figure 4 ;

la figure 6 représente sous la forme de blocs un exemple plus détaillé d'une variante de réalisation du filtre de la figure 4 ;

la figure 7 représente sous la forme de bloc un exemple de mode de réalisation d'une partie d'un circuit des figures 5 et 6 ;

la figure 8 représente sous la forme de bloc un exemple de mode de réalisation d'une partie d'un circuit de la figure 7 ; et

la figure 9 représente sous la forme de blocs un exemple de mode de réalisation d'un émetteur radiofréquence.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

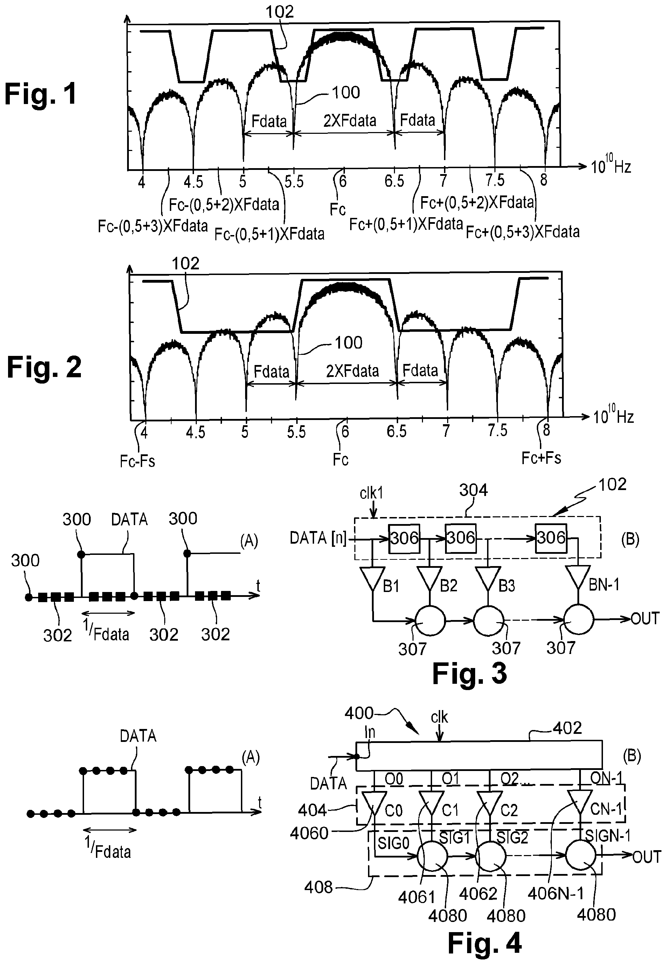

La figure 1 illustre un exemple de répartition spectrale 100 de la puissance d'un signal radiofréquence émis, et la réponse spectrale 102 d'un exemple de filtre.

Plus particulièrement, dans cet exemple, la figure 1 illustre la répartition spectrale 100 de la puissance d'un signal radiofréquence ayant une fréquence porteuse Fc égale à 60 GHz, modulé en QPSK (de l'anglais "quadrature phase shift keying" - modulation en quadrature de phase) avec une fréquence de données Fdata égale à 5 GHz. En outre, dans cet exemple, le filtre 102 est un filtre numérique fonctionnant à une fréquence Fs égale à deux fois Fdata. Dit autrement, le taux de suréchantillonnage OSR du signal à filtrer, qui correspond au ratio Fs/Fdata, est ici égal à 2. Le filtre 102 est, par exemple, un filtre d'interpolation, par exemple un filtre passe bas à réponse impulsionnelle finie.

Comme cela se voit en figure 1, la puissance 100 du signal émis présente un lobe principal centré sur Fc et de largeur égale à deux fois Fdata, et des lobes secondaires centrés sur Fc-(0,5+m)*Fdata et Fc+(0,5+m)*Fdata et de largeur égale à Fdata, avec m un indice entier strictement positif. En figure 1, seuls les lobes secondaires correspondants à m égal à 1, 2 ou 3 sont représentés.

Le filtre 102 est ici conçu que 99 % de la puissance 100 soit comprise dans une plage de fréquences allant de 56,5 GHz à 62,5 GHz, en considérant que 100 % de la puissance émise est comprise entre 42,5 GHz et 77,5 GHz. La réponse du filtre numérique 102 centrée sur la fréquence Fc est définie sur une bande de fréquence de largeur égale à Fs. Toutefois, la réponse du filtre autour de la fréquence Fc se retrouve également autour des fréquences égales à Fc-m*Fs et Fc+m*Fs. A titre d'exemple, le filtre 102 est de type à cosinus surélevés ("raised cosine" en anglais).

Comme l'illustre la figure 1, certains lobes secondaires, à savoir les lobes secondaires correspondant à m égal 1 et m égal 2, ne sont pas assez filtrés, d'où il résulte que plus de 1% de la puissance du signal émis l'est à des fréquences hors de la plage allant de 56,5 GHz à 62,5 GHz.

La figure 2 illustre un exemple de répartition spectrale 100 de la puissance pour le même exemple de signal émis qu'en figure 1, et la réponse spectrale 102 du même exemple de filtre qu'en figure 1 à la différence que, en figure 2, le taux de suréchantillonnage OSR du signal émis est égal à 4.

Dit autrement, en figure 2, la fréquence Fs du filtre numérique 102 est égal à 20 GHz dans cet exemple où Fdata est égal à 5 GHz. Comme en figure 1, la réponse du filtre numérique 102 centrée sur la fréquence Fc se retrouve également autour des fréquences égales à Fc-m*Fs et Fc+m*Fs. Toutefois, dans l'exemple de la figure 2, la fréquence Fs est doublée par rapport à l'exemple de la figure 1.

Ainsi, contrairement à ce qui a été décrit en relation avec la figure 1, dans l'exemple de la figure 2, les lobes secondaires sont suffisamment filtrés pour qu'au moins 99% de la puissance du signal émis soit comprise dans la plage allant de 56,5 GHz à 62,5 GHz.

Les figures 1 et 2 montrent qu'un filtre numérique d'interpolation fonctionnant avec un taux de suréchantillonnage OSR au moins égal à 4 permet de concentrer la puissance du signal émis dans une bande de fréquences centrée sur la fréquence Fc, de sorte qu'au moins un pourcentage donné de la puissance du signal émis le soit dans cette bande de fréquences, par exemple de sorte qu'au moins 99 % de la puissance du signal émis soit comprise entre 56,5 GHz à 62,5 GHz dans l'exemple de la figure 2.

La figure 3 illustre, par deux vues A et B très schématiques, un exemple de mise en oeuvre du filtre 102 des figures 1 et 2, avec un taux de suréchantillonnage OSR égal à 4.

La vue A (à gauche en figure 3) montre l'évolution en fonction du temps d'un signal de donnée binaire DATA. Le signal DATA correspond donc à une succession de bits, l'état de chaque bit étant maintenu pendant une durée égale à 1/Fdata. Dit autrement, le signal DATA est un signal binaire à la fréquence Fdata.

Des points 300 (à gauche en figure 3) représentent un exemple d'échantillonnage du signal DATA à une fréquence égale à Fdata.

Pour suréchantillonner le signal DATA à une fréquence Fs égale à OSR*Fdata, avec OSR égal à 4 dans cet exemple, une solution connue consiste à ajouter des échantillons 302 n'introduisant pas d'énergie dans le signal DATA et ne modifiant pas la répartition fréquentielle du signal DATA. Ces échantillons 302, qui sont représentés par des carrés en figure 3, ne correspondent pas à un échantillonnage de la valeur binaire réelle du signal DATA. Dit autrement, on rajoute des échantillons 302 correspondant à une tension nulle du signal DATA. Dans l'exemple de la figure 3 où OSR est égal à 4, 3 échantillons 302 d'énergie nulle sont ajoutés après chaque échantillon 300, de sorte à obtenir des échantillons 300, 302 du signal DATA à une fréquence égale à OSR*Fdata, ou, dit autrement, un signal suréchantillonné DATA[n] à la fréquence Fdata*OSR.

La vue B (à droite en figure 3) représente de manière schématique un exemple de mise en oeuvre du filtre numérique 102 dans le cas où le filtre 102 reçoit le signal DATA[n], c'est à dire les échantillons 300, 302 du signal DATA, à la fréquence Fs=OSR*Fdata. Dans l'exemple de la figure 3, le filtre d'interpolation 102 comprend N coefficients Bi, avec i un indice entier allant de 0 à N-1.

Le filtre 102 comprend un registre à décalage 304 configuré pour recevoir les échantillons 300, 302 du signal DATA, c'est à dire pour recevoir le signal DATA[n], à la fréquence Fs.

Le registre à décalage 304 est synchronisé sur un signal d'horloge clk1 ayant une fréquence égale à la fréquence Fs.

Le registre à décalage 304 comprend des éléments à retard 306, par exemple N éléments 306, connectés en série. Dit autrement, chaque élément 306 a son entrée connectée à la sortie de l'élément 306 qui le précède et a sa sortie connectée à l'entrée de l'élément 306 qui le suit. Chaque élément à retard 306 est synchronisé sur le signal clk1. Chaque élément à retard 306 est configuré pour mettre à jour sa sortie à la fréquence Fs, par exemple à chaque front montant ou à chaque front descendant du signal clk1, puis pour maintenir constant le niveau de sa sortie jusqu'à la prochaine mise à jour de sa sortie. Ainsi, les échantillons DATA[n] se propagent dans le registre 304 à la fréquence Fs.

Le registre à décalage 304 comprend N sorties auxquelles sont appliqués N coefficients Bi respectifs, avec i entier allant de 0 à N-1. Les signaux obtenus par l'application des N coefficients Bi aux N sorties correspondantes du registre à décalage 304 sont ensuite sommés (blocs 307 en figure 3) pour obtenir un signal OUT de sortie du filtre 102.

Un problème de la mise en oeuvre décrite en relation avec la figure 3 est que le signal DATA est un signal binaire ne prenant que deux niveaux ou états, à savoir une tension nulle et une tension positive, correspondants à deux valeurs binaires '1' et '0'. Ainsi, chaque échantillon 300, 302 correspond à un bit à '1' ou à '0'. Or, appliquer un coefficient Bi à un bit 300, 302 revient à fournir un signal A lorsque le bit 300, 302 est dans un premier état binaire, par exemple '1', et à fournir un signal complémentaire -A lorsque le bit 300, 302 est dans un deuxième état binaire, par exemple '0'. Pour ne pas introduire d'énergie dans le signal DATA à filtrer, c'est à dire pour ne pas créer une composante continue (DC) non nulle sur la sortie OUT du filtre 102, il faudrait que l'application d'un coefficient Bi à un bit 302 revienne à fournir un signal de valeur nulle, ce qui pose de nombreux problèmes. En effet, cela complexifie la mise en oeuvre du filtre 102.

Par exemple, cela impose de prévoir des traitements différents entre un échantillon 300 et un échantillon 302, ce qui n'est pas souhaitable.

Par exemple, cela impose de déterminer pour chaque échantillon DATA[n] si l'échantillon correspond à un bit DATA à la valeur '1', à un bit DATA à la valeur '0' ou à un échantillon 302 correspondant à un zéro d'énergie du signal DATA. Il devient donc nécessaire de coder chaque échantillon DATA[n] par un signal numérique à au moins trois états. Par exemple, dans le cas où l'application des coefficients Bi aux échantillons DATA[n] conduit à l'obtention d'un signal OUT numérique sur plusieurs bits, cela rend complexe une étape ultérieure de conversion numérique-analogique du signal OUT. Par exemple, dans le cas où l'application des coefficients Bi aux échantillons DATA[n] se fait simultanément ou postérieurement à la conversion numérique-analogique, la conversion numérique-analogique n'est plus intrinsèquement linéaire contrairement au cas d'un convertisseur numérique analogique 1 bit.

Pour pallier les inconvénients de mise en oeuvre et de fonctionnement des filtres d'interpolations connus, il est ici proposé de suréchantillonner un signal binaire DATA à une fréquence Fs=OSR*Fdata, avec OSR au moins égal à 2, pour appliquer un filtre d'interpolation aux échantillons obtenus mais en mettant en oeuvre le suréchantillonnage sans ajout d'échantillons 302 correspondant à une énergie nulle du signal DATA. A la place, le signal DATA à la fréquence Fdata est échantillonné à la fréquence Fs égale à OSR fois Fdata, d'où il résulte que, pour chaque bit du signal DATA, c'est à dire pour chaque période de durée 1/Fdata du signal DATA, le signal échantillonné comprend un nombre OSR d'échantillons ayant la même valeur binaire '1' ou '0' déterminée par l'état binaire du bit du signal DATA. Les coefficients Bi du filtre d'interpolation 102 décrit en relation avec la figure 3 ne sont donc plus adaptés au signal DATA ainsi suréchantillonné, et des nouveaux coefficients Ci sont donc recalculés en conséquence pour obtenir la même réponse. Ces coefficients Ci sont, par exemple, calculés à partir des coefficients Bi connus.

Comme cela sera décrit plus bas en relation avec un exemple particulier de filtre d'interpolation et de mise en oeuvre, la solution proposée ici permet de réduire la surface et la complexité du circuit mettant en oeuvre le filtre par rapport à la mise en oeuvre de la figure 3, et ainsi d'être compatible avec la propagation des signaux radiofréquences dans le filtre.

La figure 4 illustre, par deux vues A et B très schématiques, un mode de réalisation d'un filtre d'interpolation 400. Le filtre 400 est par exemple configuré pour fournir le même signal OUT que le filtre 102 de la figure 3, ou, dit autrement, pour avoir la même réponse que le filtre d'interpolation 102 utilisé avec le signal DATA suréchantillonné à un taux OSR égal à 4 par ajout d'échantillons 302 d'énergie nulle. A titre d'exemple, le dispositif 400 est mis en oeuvre dans un émetteur radiofréquence, non illustré en figure 4.

La vue A (à gauche en figure 4) montre l'évolution en fonction du temps du signal de donnée binaire DATA correspondant à une succession de bits à la fréquence Fdata. Des points 400 représentent les échantillons du signal DATA suréchantillonné à Fs=OSR*Fdata, avec OSR égal à 4 dans cet exemple.

La vue B (à droite en figure 4) représente de manière schématique, un mode de réalisation du dispositif de filtrage 400 dans le cas où le signal DATA est échantillonné à la fréquence Fs. De manière similaire au filtre 102 qui est défini par N coefficients Bi, le filtre 400 est défini par N coefficients Ci. Comme cela sera décrit par la suite, pour obtenir une même réponse OUT avec le filtre de la figure 4 qu'avec celui de la figure 3, le nombre N de coefficients Ci est plus faible que le nombre N de coefficients Bi. En outre, la mise en oeuvre des N coefficients Ci est bien plus compacte que la mise en oeuvre des N coefficients Bi. Bien que cela sera décrit pour un exemple particulier de filtre d'interpolation et de mise en oeuvre des coefficients, ces avantages se retrouvent avec d'autres exemples de filtres d'interpolation et/ou d'autres mises en oeuvre des coefficients.

Le dispositif de filtrage, ou filtre, 400 comprend un registre à décalage 402. Le registre à décalage 402 est de type série/parallèle. Le registre 402 comprend donc une entrée série In et une pluralité N de sorties parallèles Oi, avec i un indice entier allant de 0 à N-1 et N un entier positif supérieur ou égal à OSR.

L'entrée In est une entrée binaire, c'est à dire qu'elle est configurée pour recevoir un signal binaire, à savoir le signal DATA. Chaque sortie Oi est une sortie binaire, c'est à dire qu'elle est configurée pour fournir un signal binaire. Dans la suite de la description, on désigne par une même référence Oi une sortie du registre 402 et le signal binaire ou bit présent sur cette sortie. Dans la présente description, un signal binaire est un signal pouvant prendre deux niveaux ou états, par exemple une tension nulle et une tension positive, correspondant à deux valeurs binaires '0' et '1'. Dit autrement, un signal binaire correspond à une succession de bits, les bits se succédant à une fréquence donnée, par exemple à la fréquence Fdata dans le cas du signal DATA.

Le registre à décalage 402 est configuré pour mettre en oeuvre des décalages à la fréquence Fs. Dit autrement, le registre à décalage 402 est configurée pour que chaque sortie Oi du registre 402 (à l'exception de la sortie O0) fournisse le bit de la sortie Oi-1 avec un retard égal à 1/(Fdata*OSR), et que les sorties Oi soient mises à jour à la fréquence Fs. Dit encore autrement, le registre 402 est configuré pour transmettre chaque bit du signal DATA reçu sur son entrée In, sur ses sorties Oi avec des retards multiples de 1/(Fdata*OSR) et déterminés, pour chaque sortie Oi, par l'indice i de cette sortie. Par exemple, chaque sortie Oi reçoit l'état binaire présent sur l'entrée In du registre 402 avec un retard égal à Hi*(1/(Fdata*OSR)), où Hi est un entier déterminé par i et, de préférence, Hi+1 = 1 + Hi. Dit encore d'une autre façon, le registre 402 est configuré pour qu'à chaque commutation de chaque sortie Oi, la sortie Oi reste au même état binaire pendant une durée 1/(Fdata*OSR) à partir de cette commutation.

Selon un mode de réalisation, le registre 402 comprend des verrous synchrones ("latch" en anglais) actifs sur niveau. Les verrous synchrones, de préférence N verrous synchrones, sont connectés en série. Pour que les décalages dans le registre 402 s'effectuent à la fréquence Fs, les verrous en série sont commandés par un signal d'horloge clk à une fréquence Fclk=(OSR/2)*Fdata, et les verrous sont connectés en série en alternant les verrous actifs sur un premier niveau, par exemple haut, du signal clk, et les verrous actifs sur un deuxième niveau, par exemple bas, du signal clk. Les sorties Oi correspondent aux sorties des verrous, de préférence aux sorties des N verrous en série. Dans un tel mode de réalisation, une bascule synchrone de type D peut être prévue entre l'entrée In du registre et le premier verrou de la connexion en série desdits verrous. Cette bascule D est synchronisée avec le signal clk, et plus particulièrement sur un type donné, par exemple montant ou descendant, de fronts du signal clk. Une telle bascule D permet de maintenir, pour chaque bit du signal DATA, un état stable pendant une durée 1/Fdata sur l'entrée du premier verrou de la pluralité de verrous en série, par exemple pour éviter des problèmes pouvant survenir lorsque le signal DATA n'est pas synchronisé avec le signal clk.

Selon un autre mode de réalisation, le registre à décalage 402 comprend des bascules synchrones de type D ("D flip-flop" en anglais). Les bascules D, de préférence N bascules D, sont connectées en série. Pour que les décalages dans le registre 402 s'effectuent à la fréquence Fs, les bascules en série sont commandées par un signal d'horloge clk à une fréquence Fclk=OSR*Fdata, et sont toutes actives sur un même type de front, par exemple montant, du signal clk. Les sorties Oi correspondent aux sorties des bascules, de préférence aux sorties des N bascules.

Selon encore un autre mode de réalisation, le registre à décalage 402 comprend des bascules synchrones de type D ("D flip-flop" en anglais), les bascules D, de préférence N bascules D, étant connectées en série. Pour que les décalages dans le registre 402 s'effectuent à la fréquence Fs, les bascules en série sont commandées par un signal d'horloge clk à une fréquence Fclk=(OSR/2)*Fdata, et sont connectées en série en alternant les bascules actives sur un premier niveau, par exemple haut, du signal clk, et les bascules actives sur un deuxième niveau, par exemple bas, du signal clk. Les sorties Oi correspondent aux sorties des bascules, de préférence aux sorties des N bascules.

La prévision d'un registre 402 dans lequel les décalages s'opèrent à la fréquence Fs et qui est commandé par un signal clk à la fréquence Fclk=(OSR/2)*Fdata permet de réduire les commutations et donc la consommation et le bruit de commutation par rapport à un registre 402 dans lequel les décalages s'opèrent à la fréquence Fs mais qui est commandé par un signal clk à la fréquence Fclk=OSR*Fdata. En outre, il est plus simple de générer et propager jusqu'aux éléments du registre 402 un signal d'horloge à la fréquence (OSR/2)*Fdata plutôt qu'à la fréquence OSR*Fdata.

La prévision d'un registre 402 comprenant N verrous en série fournissant les N sorties Oi du registre 402 permet de réduire l'encombrement par rapport à un registre 402 comprenant N bascules D en série fournissant les N sorties Oi du registre 402.

Par rapport à ce qui a été décrit en relation avec la figure 3, suréchantillonner le signal binaire DATA à une fréquence Fs=OSR*Fdata, avec OSR au moins égal à 2, et sans ajout d'échantillons 302 correspondant à une énergie nulle du signal DATA permet de limiter le nombre de commutation des sorties binaires Oi du registre 402, en particulier quand le signal DATA reste pendant plusieurs périodes 1/Fdata successives à un état binaire correspondant à un échantillon 300 d'énergie non nul.

On comprend ici que, contrairement au registre 304 du filtre 102 de la figure 3, le registre 402 du dispositif 400 ne prend pas en entrée In un signal DATA[n] suréchantillonné à Fs=OSR*Fdata par ajout d'échantillons 302 à énergie nulle, mais directement le signal binaire DATA à la fréquence Fdata. L'échantillonnage (ou suréchantillonnage) du signal DATA à la fréquence Fs=OSR*Fdata est mis en oeuvre par le registre 402 lui-même.

Le dispositif 400 comprend en outre un circuit 404. Le circuit 404 est défini, ou déterminé, par les N coefficients Ci. Le circuit 404 est configuré pour fournir, pour chaque coefficient Ci non nul, un signal SIGi analogique, par exemple un courant, déterminé par ledit coefficient Ci et par un état binaire de la sortie Oi correspondant à ce coefficient Ci, c'est à dire la sortie Oi ayant le même indice i que ce coefficient Ci.

A titre d'exemple, pour chaque coefficient Ci non nul, le circuit 404 comprend un circuit 406i configuré pour recevoir la sortie Oi correspondante et pour fournir le signal SIGi déterminé par l'état binaire de la sortie Oi et par le coefficient Ci.

A titre d'exemple, le circuit 404 est configuré pour fournir, pour chaque coefficient Ci non nul, par exemple avec le circuit 406i correspondant, le signal analogique SIGi à une première valeur proportionnelle ou égale au coefficient Ci lorsque la sortie Oi est dans un premier état binaire, par exemple l'état '1', et à une deuxième valeur proportionnelle ou égale au coefficient Ci lorsque la sortie Oi est dans un deuxième état binaire, par exemple l'état '0'. De préférence la deuxième valeur est égale à moins la première valeur.

A titre d'exemple, le circuit 404 est configuré pour fournir, pour chaque coefficient Ci non nul, un signal SIGi analogique déterminé par ledit coefficient Ci, par un état binaire de la sortie Oi correspondant à ce coefficient Ci et en outre par un signal périodique SIGLO (non représenté en figure 4). A titre d'exemple, le circuit 404, par exemple chaque circuit 406i, reçoit le signal périodique SIGLO, par exemple à la fréquence Fc. A titre d'exemple, le circuit 404 est alors configuré pour fournir, pour chaque coefficient Ci non nul, par exemple avec le circuit 406i correspondant, un signal analogique SIGi ayant une première valeur proportionnelle, de préférence égale, à SIGLO*Ci lorsque la sortie Oi est dans un premier état binaire, par exemple l'état '1', et ayant une deuxième valeur proportionnelle, de préférence égale, à -SIGLO*Ci lorsque la sortie Oi est dans un deuxième état binaire, par exemple l'état '0'.

Le dispositif 400 comprend en outre un circuit sommateur 408. Le circuit 408 est configuré pour fournir un signal analogique de sortie OUT du circuit de filtrage 400 qui est égal à, ou déterminé par, la somme des signaux analogiques SIGi. A titre d'exemple, le circuit 408 peut mettre en oeuvre une fonction d'adaptation d'impédance de la sortie OUT. A titre d'exemple, le circuit 408 est configuré pour recevoir les signaux SIGi de sortie du circuit 404.

A titre d'exemple, le circuit 408 comprend un noeud configuré pour recevoir tous les signaux analogiques SIGi, et pour fournir le signal analogique OUT, chaque signal SIGi correspondant par exemple à un courant.

A titre d'exemple alternatif, le circuit sommateur 408 comprend plusieurs circuits 4080 configurés pour recevoir les signaux SIGi et les sommer. Par exemple, chaque circuit 4080 est configuré pour recevoir un signal SIGi, le sommer avec la somme des signaux SIG0 à SIGi-1 fournit par le circuit 4080 précédant et pour fournir la somme des signaux SIG0 à SIGi au circuit 4080 suivant comme cela est représenté en Figure 4, vue (B), le circuit 4080 recevant le signal SIGN-1 fournissant le signal OUT. Par exemple, les circuits 4080 partagent un même noeud commun à tous les circuits 4080 sur lequel les signaux SIGi sont sommés et sur lequel est disponible le signal de sortie OUT. A titre d'exemple, chaque circuit 4080 peut mettre en oeuvre une fonction d'adaptation d'impédance entre le signal SIGi reçu et le signal OUT de sortie du circuit 408.

A titre d'autre exemple alternatif, le circuit 408 peut être implémenté par un réseau d'adaptation d'impédance radiofréquence recevant comme entrées distribuées les signaux SIGi et fournissant la sortie OUT, la réalisation d'un tel réseau d'adaptation d'impédance radiofréquence au moyen d'inductances couplées (transformateurs) et/ou de lignes de transmission étant à la portée de la personne du métier.

Lorsque le filtre 400 est un filtre à réponse impulsionnelle et qu'il fournit le signal analogique OUT directement à partir des sorties binaires Oi, c'est à dire à partir des échantillons binaires du signal DATA échantillonnée à Fs, le dispositif 400 est par exemple appelé filtre à Réponse Impulsionnelle Finie à Conversion Numérique-Analogique (filtre FIRDAC de l'anglais "Finite Impulse Response Digital to Analog Conversion"). Lorsqu'en outre le signal OUT, par exemple chaque signal SIGi, est déterminé ou dépend du signal périodique SIGLO, le filtre 400 est par exemple appelé filtre FIRDAC mixeur ("mixing FIRDAC" en anglais).

Selon un mode de réalisation, les N coefficients Ci du dispositif 400 sont déterminés par la réponse impulsionnelle h(t) d'un filtre d'interpolation, par exemple de type à cosinus surélevé.

Un exemple d'un mode de réalisation de détermination des coefficients Ci va maintenant être décrit en relation avec le tableau Table 1 ci-dessous, dans le cas où l'on considère, à titre d'exemple, la réponse impulsionnelle h(t) définie par la formule suivante :

$$h(t) = \begin{cases} \dfrac{\sin(\pi t/T)}{(\pi t/T)} \cdot \dfrac{\pi}{4} \; si \; \dfrac{t}{T} = \mp\dfrac{1}{2\beta} \\ \dfrac{\sin(\pi t/T)}{(\pi t/T)} \cdot \dfrac{\cos(\pi\beta t/T)}{1-(2\beta t/T)^2} \; sinon \end{cases}$$

avec β un facteur de réduction ("roll-off factor" en anglais) compris entre 0 et 1, et T la période du signal DATA égale à 1/Fdata.

La réponse h(t) ci-dessous est normalisée, c'est à dire que son amplitude maximale est égale à 1, et est en outre centrée sur t=0.

P coefficients Bp peuvent alors être calculés à partir de la réponse h(t), en utilisant la formule suivante :

```
Bp = h((2*p-P+1)/(2*OSR)),
```

avec p un indice entier allant de 0 à P-1, P un entier impair positif et supérieur ou égal à N et OSR le taux de suréchantillonnage.

Dans l'exemple considéré, P est égal à 25 et le facteur de réduction β est égal à 0,65 bien que la présente description ne se limite pas à cet exemple particulier. Les coefficients Bp sont listés dans la colonne col1 du tableau Table 1, et leurs valeurs décimales sont listées dans la colonne col2 du tableau Table 1. Dans cet exemple, OSR est égal à 4.

[Table 1]

| col1 | col2 | col3 | col4 | col5 | col6 | col7 |
|------|------|------|------|------|------|------|
| B0 | 0.00 | 0 | D0 | 0.00 | | |
| B1 | 0.00 | 0 | D1 | 0.00 | | |
| B2 | 0.00 | 0 | D2 | 0.00 | | |
| B3 | 0.00 | 0 | D3 | 0.00 | | |
| B4 | 0.00 | 0 | D4 | 0.00 | | |
| B5 | -0.03 | -1 | D5 | -0.03 | C0 | -1 |
| B6 | -0.08 | -2 | D6 | -0.05 | C1 | -1 |
| B7 | -0.09 | -2 | D7 | -0.01 | C2 | 0 |
| B8 | 0.00 | 0 | D8 | 0.09 | C3 | 2 |
| B9 | 0.24 | 6 | D9 | 0.21 | C4 | 5 |
| B10 | 0.58 | 14 | D10 | 0.29 | C5 | 7 |
| B11 | 0.88 | 21 | D11 | 0.29 | C6 | 7 |
| B12 | 1.00 | 24 | D12 | 0.21 | C7 | 5 |
| B13 | 0.88 | 21 | D13 | 0.09 | C8 | 2 |
| B14 | 0.58 | 14 | D14 | -0.01 | C9 | 0 |
| B15 | 0.24 | 6 | D15 | -0.05 | C10 | -1 |

(suite)

| col1 | col2 | col3 | col4 | col5 | col6 | col7 |
|------|------|------|------|------|------|------|
| B16 | 0.00 | 0 | D16 | -0.03 | C11 | -1 |
| B17 | -0.09 | -2 | D17 | 0.00 | | |
| B18 | -0.08 | -2 | D18 | 0.00 | | |
| B19 | -0.03 | -1 | D19 | 0.00 | | |
| B20 | 0.00 | 0 | D20 | 0.00 | | |
| B21 | 0.00 | 0 | D21 | 0.00 | | |
| B22 | 0.00 | 0 | D22 | 0.00 | | |
| B23 | 0.00 | 0 | D23 | 0.00 | | |
| B24 | 0.00 | 0 | D24 | 0.00 | | |

Des coefficients Dp sont alors calculés, de manière récursive à partir de l'indice p le plus faible, à partir des coefficients Bp ci-dessus, en utilisant la formule suivante :

$$Dp = Bp - \sum_{j=p-OSR+1}^{j=p-1} Dj \, ,$$

où j est un indice entier, Dj est nul lorsque j est strictement négatif. Plus particulièrement, pour un indice p donné, l'indice j de la somme est un indice entier allant de p-OSR+1 à p-1, avec Dj nul lorsque que j est négatif. Par exemple, les coefficients Dp sont calculés de manière récursive en réutilisant, pour calculer le coefficient Dp d'indice p donné, au moins certains des coefficient Dp (c'est à dire Dj dans la formule ci-dessus) déjà calculés pour les indices p de valeurs inférieures à l'indice p donné. Dit encore autrement, dans la formule ci-dessus, Dj = Dp lorsque les indices j et p sont égaux et que j est positif ou nul, et Dj est nul lorsque l'indice j strictement négatif.

Les coefficients Dp sont listés dans la colonne col4 du tableau Table 1, et leurs valeurs décimales sont listées dans la colonne col5.

Par exemple, en reprenant la formule ci-dessus et l'exemple du tableau Table 1 où OSR = 4 :

- pour p = 0, on obtient :

$$D0 = B0 - \sum_{j=-3}^{j=-1} Dj = B0 - 0 = 0.00$$

- pour p = 1, on obtient :

$$D1 = B1 - \sum_{j=-2}^{j=0} Dj = B1 - D0 = 0.00$$

- pour p = 2, on obtient :

$$D2 = B2 - \sum_{j=-1}^{j=1} Dj = B2 - D0 - D1 = 0.00$$

- pour p = 3, on obtient :

$$D3 = B3 - \sum_{j=0}^{j=2} Dj = B3 - D0 - D1 - D2 = 0.00$$

- pour p = 4, on obtient :

$$D4 = B4 - \sum_{j=1}^{j=3} Dj = B4 - D1 - D2 - D3 = 0.00$$

- pour p = 5, on obtient :

$$D5 = B5 - \sum_{j=2}^{j=4} Dj = B5 - D2 - D3 - D4 = -0.03$$

- pour p = 6, on obtient :

$$D6 = B6 - \sum_{j=3}^{j=5} Dj = B6 - D3 - D4 - D5 = -0.05.$$

En poursuivant les calculs de l'exemple donné ci-dessus pour p allant de 7 à 24, la personne du métier sera en mesure de retrouver les valeurs indiquées en colonne 5.

Les N coefficients Ci correspondent alors à N coefficients successifs Dp parmi les P coefficients Dp. Dit autrement, pour i allant de 0 à N-1, chaque coefficient Ci est égal à un coefficient Dp d'indice p entier égal à i+min, min étant un entier.

Le nombre N de coefficients Ci et à quels N coefficients Dp correspondent les N coefficients Ci, c'est à dire la valeur de l'entier min, sont par exemple déterminés par une erreur visée sur la réponse impulsionnelle du filtre par rapport à une réponse impulsionnelle idéale. La sélection de la valeur N et/ou des coefficients Ci (c'est à dire de l'entier min) est à la portée de la personne du métier.

Dans l'exemple illustré par le tableau Table 1, min égal 5 et N égal 12. Les coefficients Ci sont listés dans la colonne col6 du tableau Table 1, la valeur décimale de chaque coefficient Ci étant donnée par la case de la colonne col5 et de la ligne du coefficient Ci.

Le calcul des valeurs décimales des coefficients Ci ne se limite pas à l'exemple de mode de réalisation décrit ci-dessus, et la personne du métier est en mesure, à partir de la réponse impulsionnelle h(t) d'un filtre d'interpolation, de calculer les valeurs décimales des coefficients Bi permettant d'obtenir la réponse visée lorsque le filtre est appliqué à des échantillons DATA[n] à la fréquence Fs obtenu à partir du signal DATA et par ajout d'échantillons d'énergie nulle, et d'en déduire les coefficients Ci permettant d'obtenir la même réponse lorsque le filtre 400 est appliqué au signal DATA échantillonné à la fréquence Fs, sans ajout d'échantillon d'énergie nulle.

Selon un mode de réalisation, plutôt que d'utiliser les valeurs décimales des coefficients Ci, des coefficients Ci ayant une valeur entière sont utilisées. La valeur entière de chaque coefficient Ci correspond à l'arrondi entier du produit de la valeur décimale du coefficient Ci par un nombre entier positif INT identique pour tous les coefficients Ci. La personne du métier est en mesure de déterminer la valeur INT en fonction d'une erreur maximale visée entre la réponse idéale du filtre et la réponse réelle du filtre 400 mis en oeuvre avec les coefficients Ci entiers. La colonne col7 du tableau Table 1 ci-dessus illustre les valeurs entières des coefficients Ci pour un exemple où l'entier INT est égal à 24.

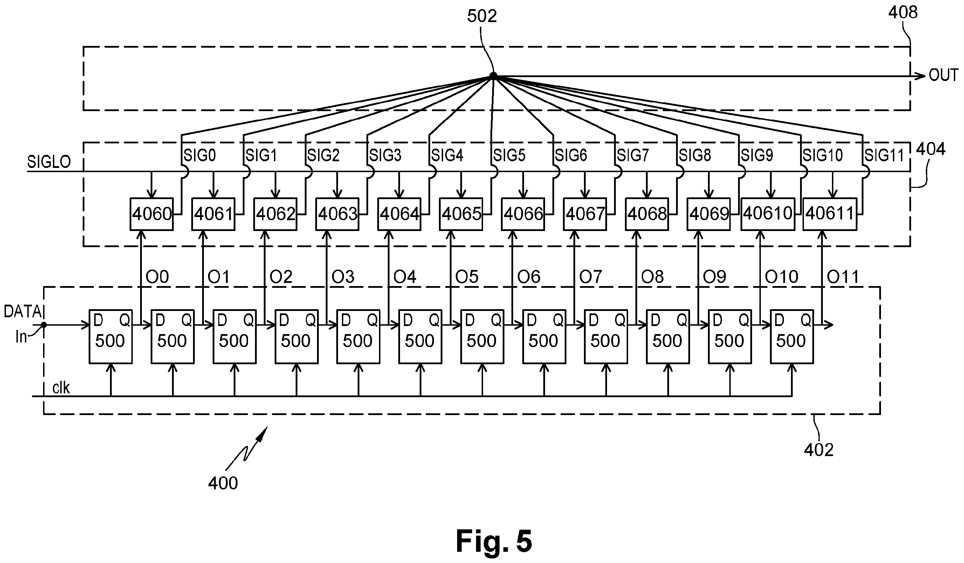

La figure 5 représente sous la forme de blocs un exemple plus détaillé d'un mode de réalisation du filtre 400 de la figure 4. Dans cet exemple, le filtre 400 est mis en oeuvre avec des coefficients Ci entiers, et, plus particulièrement avec les coefficients Ci entiers du tableau Table 1 ci-dessus. Dans d'autres exemples non illustrés, le filtre 400 est mis en oeuvre avec des coefficients Ci décimaux, par exemple avec les coefficients Ci dont les valeurs décimales sont illustrées par la colonne col5 du tableau Table 1 ci-dessus.

La figure 5 illustre un mode de réalisation dans lequel le registre à décalage 402 est mis en oeuvre à partir de, ou comprend, N bascules D 500 connectées en série et commandées par un signal clk à la fréquence Fclk=Fdata*OSR=Fs. Les bascules 500 sont toutes actives sur le même type de front (montant ou descendant) du signal clk, par exemple sur front montant du signal clk.

Chacune des N bascules 500 comprend une entrée de synchronisation configurée pour recevoir le signal clk.

Chacune des N bascules 500 comprend une entrée de donnée D connectée à la sortie Q de la bascule qui la précède dans la connexion de N bascules 500 en série, à l'exception de la première bascule qui reçoit le signal DATA sur son entrée D. Chacune des N bascules 500 a sa sortie qui fournit une sortie Oi correspondante du circuit 402. Par exemple, la première des N bascules 500 en série fournit la sortie O0, la deuxième des N bascules 500 en série fournit la sortie O1, et ainsi de suite jusqu'à la Nième des N bascules 500 en série qui fournit la sortie ON, à savoir la sortie O11 dans cet exemple.

Dans ce mode de réalisation, pour chaque coefficient Ci non nul, le circuit 404 comprend un circuit 406i configuré pour recevoir la sortie Oi correspondante et pour fournir le signal SIGi déterminé par l'état binaire de la sortie Oi et par le coefficient Ci. Comme cela est illustré par la figure 5, le circuit 404 peut également comprendre, pour chaque coefficient Ci nul, un circuit 406i correspondant mais qui est alors configuré pour fournir un signal SIGi nul quel que soit l'état de la sortie Oi reçue par ce circuit 406i. A titre d'exemple, chaque circuit 406i comprend une entrée configurée pour recevoir la sortie Oi. Dans un autre exemple, les circuits 406i correspondant à des coefficients Ci nuls sont omis.

A titre d'exemple, et bien que cela ne soit pas illustré en figure 5, chaque circuit 406i peut également comprendre une entrée configurée pour recevoir un signal binaire OCompi complémentaire de la sortie Oi, c'est à dire un signal OCompi au niveau haut, respectivement bas, quand la sortie Oi est au niveau bas, respectivement haut. De préférence, les signaux Oi et OCompi ont les mêmes niveaux hauts et les mêmes niveaux bas. A titre d'exemple, chaque bascule 500 est configurée pour fournir le signal OCompi complémentaire du signal Oi fourni par sa sortie Q. Dans un autre exemple, chaque circuit 406i ne reçoit pas le signal OCompi.

Dans l'exemple de la figure 5, le signal SIGi de sortie de chaque circuit 406i est en outre déterminé par le signal périodique SIGLO. Ainsi, chaque circuit 406i comprend alors une entrée configurée pour recevoir le signal SIGLO. A titre d'exemple, le signal SIGLO est un signal différentiel comprenant une composante SIGLO+ et une composante SIGLO- en opposition de phase avec la composante SIGLO+.

Dans ce mode de réalisation, le circuit 408 comprend un noeud 502. A titre d'exemple, le noeud 502 est connecté à une sortie de chaque circuit 406i correspondant à un coefficient Ci non nul, cette sortie du circuit 406i fournissant le signal, par exemple un courant, SIGi correspondant. A titre d'exemple alternatif, le noeud 502 est connecté à la sortie de chaque circuit 406i sur laquelle est disponible le signal SIGi du circuit 406i. Le noeud 502 est configuré pour fournir le signal, par exemple un courant, OUT de sortie du filtre 400.

A titre de mode de réalisation alternatif non illustré, le circuit sommateur 408 comprend plusieurs circuits 4080 comme cela a été décrit en relation avec la figure 4, vue (B).

Dans un autre mode de réalisation alternatif non illustré, le circuit 408 comprend un réseau d'adaptation d'impédance radiofréquence recevant comme entrées distribuées les signaux SIGi et fournissant la sortie OUT, la réalisation d'un tel réseau d'adaptation d'impédance radiofréquence au moyen d'inductances couplées (transformateurs) et/ou de lignes de transmission étant à la portée de la personne du métier.

Bien que l'on ait décrit en relation avec la figure 5 un exemple dans lequel le filtre 400 un filtre FIRDAC mixeur, c'est à dire qu'il met en oeuvre une fonction de mixage avec le signal SIGLO, dans d'autres exemples non illustrés, cette fonction de mixage est omise et le signal OUT, chaque circuit 406i ne recevant alors pas le signal SIGLO.

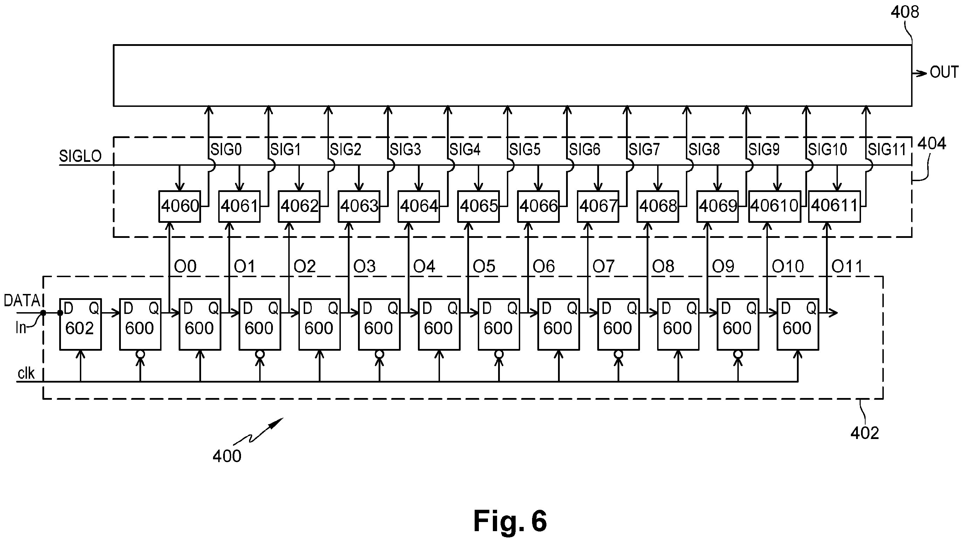

La figure 6 représente sous la forme de blocs un exemple plus détaillé d'une variante de réalisation du filtre 400. Comme en figure 5 de la figure 4, le filtre 400 est mis en oeuvre avec les coefficients Ci entiers du tableau Table 1 ci-dessus, bien que, dans d'autres exemples, le filtre 400 soit mis en oeuvre avec des coefficients Ci décimaux. En figure 6, le circuit 408 n'a pas été détaillé, ce circuit 408 étant par exemple mis en oeuvre comme cela a été décrit précédemment en relation avec les figures 4 et 5.

Le filtre 400 de la figure 6 diffère de celui de la figure 5 uniquement par la mise en oeuvre du registre à décalage 402. Ainsi, tout ce qui a été indiqué pour le filtre 400 de la figure 5 et qui ne concerne pas directement le registre à décalage 402 s'applique au filtre 400 de la figure 6.

Plus exactement, dans la variante de la figure 6, le registre 402 à décalage 402 est mis en oeuvre à partir de, ou comprend, N verrous 600 ("latch" en anglais) connectées en série et commandées par un signal clk à la fréquence Fclk=Fdata*OSR/2=Fs/2. Les N verrous sont connectés en série en alternant les verrous actifs sur un premier niveau, par exemple haut, du signal clk, et les verrous actifs sur un deuxième niveau, par exemple bas, du signal clk. A titre d'exemple, le premier des N verrous en série est actif sur niveau bas du signal clk. Chacun des N verrous 600 comprend une entrée de synchronisation configurée pour recevoir le signal clk.

Chacun des N verrous 600 comprend une entrée de donnée D connectée à la sortie Q du verrou 600 qui le précède dans la connexion des N verrous 600 en série, à l'exception du premier verrou 600. Chacun des N verrous 600 a sa sortie qui fournit une sortie Oi correspondante du circuit 402. Par exemple, le premier des N verrous 600 en série fournit la sortie O0, le deuxième des N verrous 600 en série fournit la sortie O1, et ainsi de suite jusqu'au Nième des N verrous 600 en série qui fournit la sortie ON, à savoir la sortie O11 dans cet exemple.

A titre d'exemple, dans le mode de réalisation illustré en figure 6, le registre à décalage 402 comprend en outre une bascule synchrone de type D 602 entre l'entrée In du registre 402 et le premier des N verrous 600 en série. Cette bascule D est synchronisée avec le signal clk, et plus particulièrement sur un type donné, par exemple montant ou descendant, de fronts du signal clk, par exemple sur front montant dans l'exemple de la figure 6. La bascule 602 comprend une entrée D configurée pour recevoir le signal DATA et une sortie Q connectée à l'entrée D du premier des N verrous 600 en série. Dans un autre exemple non illustré, cette bascule 602 peut être omise, l'entrée D du premier des N verrous 600 en série recevant alors directement le signal DATA.

Un avantage de la variante de réalisation de la figure 6 par rapport au mode de réalisation de la figure 5 est que le registre 402 est commandé par un signal clk à la fréquence Fs/2 plutôt que par un signal clk à la fréquence Fs, ce qui réduit le nombre de commutation, donc la consommation, dans le registre 402 bien que les registres 402 aient des sorties Oi similaires.

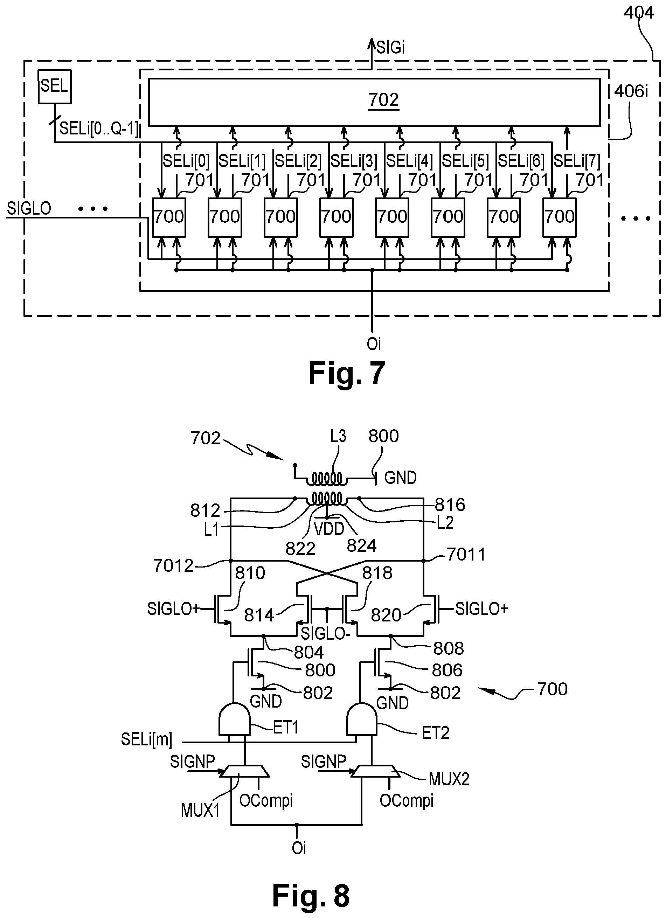

La figure 7 représente sous la forme de bloc un exemple de mode de réalisation d'une partie du circuit 404 des figures 4, 5 et 6. Plus particulièrement, la figure 7 illustre un exemple de mode de réalisation des circuits 406i du circuit 402, un seul circuit 406i étant représenté en figure 7.

Le circuit 406i comprend plusieurs circuits élémentaires identiques 700.

Chaque circuit 700 est configuré pour recevoir le signal Oi correspondant au circuit 406i auquel il appartient.

Chaque circuit 700 comprend une sortie 701 configurée pour fournir :

un signal analogique S0 lorsque la sortie Oi reçue par ce circuit 700 est dans un premier état binaire, par exemple l'état '1' correspondant par exemple à un niveau haut de la sortie Oi, et que le coefficient Ci est positif ;
un signal S1 complémentaire du signal S0 lorsque la sortie Oi reçue par ce circuit 700 est dans un deuxième état binaire,
par exemple l'état '0' correspondant par exemple à un niveau bas de la sortie Oi, et que le coefficient Ci est positif ;
le signal S1 lorsque la sortie Oi reçue par ce circuit 700 est dans le premier état binaire et que le coefficient Ci est négatif ; et
le signal S0 lorsque la sortie Oi reçue par ce circuit 700 est dans le deuxième état binaire et que le coefficient Ci est négatif.

A titre d'exemple, pour chaque circuit 700, la sortie 701 comprend un unique noeud sur lequel est disponible le signal de sortie du circuit 700, par exemple un courant. A titre d'exemple alternatif, pour chaque circuit 700, la sortie 701 comprend deux noeuds entre lesquels est disponible le signal de sortie du circuit 700, par exemple une tension.

Les sorties 701 des circuits 700 sont connectées à un circuit sommateur 702 du circuit 406i. Le circuit 702 est configuré pour recevoir les signaux de sortie des circuit 700 et pour les sommer de sorte à fournir, par exemple, le signal SIGi. A titre d'exemple, le circuit 702 peut mettre en oeuvre une fonction d'adaptation d'impédance entre les signaux S0, S1 qu'il reçoit et le signal de sortie qu'il fournit.

A titre d'exemple, le circuit 702 est mis en oeuvre seulement par un noeud connecté à toutes les sorties 701 des circuits 700, les sortie 701 étant alors, par exemple, des sorties en courant qui sont directement sommés sur ce noeud. Le signal SIGi est alors disponible sur ce noeud.

A titre d'exemple alternatif, le circuit 702 comprend un réseau d'adaptation d'impédance radiofréquence recevant comme entrées distribuées les signaux de sortie des circuits 700, et fournissant en sortie le signal SIGi correspondant. La réalisation d'un tel réseau d'adaptation d'impédance radiofréquence au moyen d'inductances couplées (transformateur), et/ou de lignes de transmission est à la portée de la personne du métier.

Dans le mode de réalisation illustré par la figure 7, le circuit 404 comprend un circuit 406i pour chacun des N coefficients Ci du filtre 400. En outre, le circuit 404 comprend un circuit de sélection SEL configuré pour sélectionner, parmi la pluralité de circuit 700 du circuit 406i, Ki circuits 700 et pour éteindre les circuits 700 qui ne sont pas sélectionnés. Ki est égal à la valeur absolue de la valeur entière du coefficient Ci (voir colonne col7 du tableau Table 1 ci-dessus). Par exemple, K0 est égal à 1, et un seul circuit 700 est sélectionné parmi les Q circuits 700 du circuit 4061. Dans l'exemple illustré, chaque circuit 406i comprend Q circuits 700, avec Q égal à 8 dans cet exemple. A titre d'exemple, le circuit SEL fournit un signal SELi[0..Q-1] à chaque circuit 406i. Le signal SELi[0..Q-1] détermine Q signaux SELi[m], avec m indice entier allant de 0 à Q-1, fournis aux Q circuits 700 du circuit 406i. Par exemple, chaque signal SELi[m] indique au circuit 700 qui le reçoit si ce circuit 700 doit être éteint et fournir alors un signal nul sur sa sortie 701, ou si le circuit 700 doit fournir un signal analogique non nul sur sa sortie 701, ce signal analogique S0 ou S1 étant déterminé par l'état binaire de la sortie Oi correspondant et la polarité (signe) du coefficient Ci correspondant.

Plus particulièrement, dans l'exemple de mode de réalisation illustré par la figure 7, le filtre 400 est un FIRDAC mixeur, et chaque circuit 700 est en outre configuré pour recevoir le signal SIGLO. Chaque circuit 700, lorsqu'il est sélectionné, est alors configuré pour fournir un signal S0 en phase avec le signal SIGLO et à la même fréquence que le signal SIGLO, par exemple un courant S0 égal à A*SIGLO, et un signal S1 en opposition de phase avec le signal SIGLO, par exemple un courant S1 égal à -A*SIGLO, avec A un coefficient déterminé par la mise en oeuvre des circuits 700.

Dans un autre exemple non illustré, le filtre 400 ne met pas en oeuvre la fonction de mixeur avec le signal SIGLO, et chaque circuit 700 ne reçoit pas le signal SIGLO. Chaque circuit 700, lorsqu'il est sélectionné, est alors configuré pour fournir un signal S0, par exemple égal à un courant Iref, et un signal S1 égal à -S0. Dans cette variante, chaque circuit 700 correspond par exemple à une ou plusieurs sources de courant constant commandables et configurées pour fournir le courant constant Iref lorsque le circuit 700 doit fournir le signal S0, le courant constant -Iref lorsque le circuit 700 doit fournir le signal S1, et un courant nul lorsque le circuit 700 est éteint.

Dans le mode de réalisation illustré par la figure 7, du fait que les Ki circuits 700 de chaque circuit 406i sont sélectionnés parmi Q circuits 700 du circuit 406i, il est possible de reconfigurer le filtre 400. Par exemple, une réponse impulsionnelle h(t) différente de celle décrite précédemment à titre d'exemple peut être utilisée pour calculer les valeurs entières de nouveaux coefficients Ci correspondant à cette réponse impulsionnelle différente, et, pour chaque circuit 406i ou coefficient Ci, le circuit SEL met à jour son signal SELi[0..Q-1] de sorte à sélectionner le nombre Ki de circuits 700 calculé pour ce nouveau coefficient Ci.

Dans une variante de réalisation non illustrée, le filtre 400 n'est pas reconfigurable. Dans ce cas, le circuit 402 est dépourvu du circuit SEL, et chaque circuit 406i comprend exactement Ki circuits 700 fournissant chacun le signal S0 ou S1 selon l'état binaire de la sortie Oi qu'il reçoit. Dans une telle variante, de préférence, les circuits 406i correspondant à des coefficients Ci nuls sont omis. Bien que cette variante de réalisation ne permette plus de reconfigurer le filtre 400, elle présente l'avantage d'être moins encombrante et de consommer moins que le mode de réalisation dans lequel le filtre 400 est reconfigurable.

En se référant de nouveau au filtre 102 de la vue B de la figure 3 pour lequel le signal DATA est suréchantillonné à la fréquence Fs en ajoutant des échantillons à énergie nul, l'application de chaque coefficient Bi à la sortie Oi correspondante pourrait être mise en oeuvre par un circuit similaire au circuit 404. Dans ce cas, chaque circuit 406i comprendrait un nombre K'i de circuits élémentaires 700, avec K'i la valeur absolue de l'arrondi entier du produit du coefficient Bi par l'entier INT, l'arrondi entier du produit Bi*INT étant illustré par la colonne col3 du tableau Table 1 ci-dessus. Ainsi, dans cet exemple, le filtre 102 aurait nécessité au moins 96 circuits 700 là où le filtre 400 décrit peut comprendre seulement 24 circuits 700. La mise en oeuvre du filtre 700 est donc moins encombrante que celle du filtre 102. En outre, cela permet de s'assurer que la propagation d'un signal dans le filtre, aux fréquences considérées, est compatible avec la mise en oeuvre physique du circuit. En effet, plus le circuit est gros, plus les lignes conductrices (ou lignes de transmission) sont longues, ce peut poser problème. Les avantages de la solution proposée ici restent valables pour d'autres exemples dans lequel la réponse h(t) est différente et/ou la valeur INT est différente.

La figure 8 représente sous la forme de bloc un exemple de mode de réalisation d'un circuit 700 de la figure 7 et du circuit 702 de la figure 7. Dans cet exemple, le filtre 400 met en oeuvre la fonction de mixeur, et le circuit 700 est configuré pour recevoir le signal SIGLO, le signal SIGLO étant, dans cet exemple, un signal différentiel comprenant une composante SIGLO+ en phase et une composante SIGLO- en opposition de phase. Dans cet exemple, la sortie 701 du circuit 700 comprend deux noeuds 7011 et 7012. Le signal de sortie du circuit 700 est disponible entre ces deux noeuds 7011 et 7012.

Le circuit 700 comprend un transistor MOS ("Metal Oxide Semiconductor" - métal oxyde semiconducteur) 800 couplant un noeud de référence 802 à un noeud 804. Le noeud 802 est configuré pour recevoir une tension de référence, par exemple la masse GND. Le transistor 800 est par exemple à canal N et a, par exemple, sa source connectée au noeud 802 et son drain connecté au noeud 804.

Le circuit 700 comprend en outre un transistor MOS 806 couplant le noeud 802 à un noeud 808. A titre d'exemple, le transistor 806 est identique au transistor 800. A titre d'exemple, le transistor 800 est par exemple à canal N et a, par exemple, sa source connectée au noeud 802 et son drain connecté au noeud 808.

Le circuit 700 comprend en outre un transistor MOS 810 couplant le noeud 804 à la sortie 701 du circuit 700, et, plus particulièrement, au noeud 7012 de la sortie 701. Le transistor 810 a une grille configurée pour recevoir le signal périodique SIGLO+. Le transistor 810 est par exemple à canal N et a, par exemple, sa source connectée au noeud 804 et son drain connecté au noeud 7012.

Le circuit 700 comprend en outre un transistor MOS 814 couplant le noeud 804 à la sortie 701 du circuit 700, et, plus particulièrement, au noeud 7011 de la sortie 701. Le transistor 814 a une grille configurée pour recevoir le signal périodique SIGLO- en opposition de phase avec le signal SIGLO+. Le transistor 814 est par exemple à canal N et a, par exemple, sa source connectée au noeud 804 et son drain connecté au noeud 7011. A titre d'exemple, les transistors 810 et 814 sont identiques.

Le circuit 700 comprend en outre un transistor MOS 818 couplant le noeud 808 au noeud 7012. Le transistor 818 a une grille configurée pour recevoir le signal périodique SIGLO-. Le transistor 818 est par exemple à canal N et a, par exemple, sa source connectée au noeud 808 et son drain connecté au noeud 7012. A titre d'exemple, le transistor 818 est identique à chacun des transistors 810 et 814.

Le circuit 700 comprend en outre un transistor MOS 820 couplant le noeud 804 au noeud 7011. Le transistor 820 a une grille configurée pour recevoir le signal périodique SIGLO+. Le transistor 820 est par exemple à canal N et a, par exemple, sa source connectée au noeud 808 et son drain connecté au noeud 7011. A titre d'exemple, les transistors 818 et 820 sont identiques.

Dans ce mode de réalisation, le signal de sortie du circuit 700 est disponible entre les noeuds 7011 et 7012 de la sortie 701 du circuit 700.

Dans ce mode de réalisation, le circuit 702 comprend une inductance L1 connectée entre un noeud 812 et un noeud d'alimentation 824, et une inductance L2 connectée entre un noeud 816 et le noeud 824. Le noeud 824 est, par exemple, configuré pour recevoir une tension d'alimentation Vdd référencée à la tension de référence GND, par exemple une tension Vdd positive. Les noeuds 812 et 816 sont connectées aux sorties 701 de tous les circuits 700 d'un circuit 406i donné. Par exemple, le noeud 812 est connecté aux noeuds 7012 de tous les circuits 700 de ce circuit 406i, par exemple par l'intermédiaire d'une ligne de transmission connectée à l'inductance L1 et aux noeuds 7012 de tous les circuits 700 de ce circuit 406i. De manière symétrique, le noeud 816 est connecté aux noeuds 7011 de tous les circuits 700 de ce circuit 406i, par exemple par l'intermédiaire d'une ligne de transmission connectée à l'inductance L2 et aux noeuds 7011 de tous les circuits 700 de ce circuit 406i.

En outre, dans ce mode de réalisation, le circuit 702 comprend une inductance L3 couplée magnétiquement aux inductances L1 et L2. L'inductance L3 a une borne couplée, par exemple connectée, à la sortie du circuit élémentaire 702, et sur laquelle est, par exemple, disponible le signal de sortie SIGi du circuit 702. L'autre borne de l'inductance L3 est par exemple couplée, de préférence connectée, au noeud 802.

Dans ce mode de réalisation, le circuit 702 met en oeuvre une fonction d'adaptation d'impédance.

Lorsque le circuit 700 est l'un des Ki circuits 700 d'un circuit 406i, le transistor 800 du circuit 700 est commandé à partir de la sortie Oi correspondante, par exemple par cette sortie Oi, et le transistor 806 est commandé en opposition de phase par rapport au transistor 800 lorsque le coefficient Ci est positif, et, à l'inverse, le transistor 806 est commandé à partir de la sortie Oi, par exemple par cette sortie Oi, et le transistor 800 est commandé en opposition de phase par rapport au transistor 806 lorsque le coefficient Ci est négatif.

Dans le mode de réalisation illustré, le circuit 700 reçoit la sortie Oi et le signal complémentaire OCompi correspondant. A titre d'exemple, pour chaque sortie Oi, le circuit 402 est configuré pour fournir également le signal OCompi, par exemple car le signal OCompi est disponible sur une sortie de la bascule ou du verrou ayant une autre sortie fournissant la sortie Oi, ou au moyen d'un inverseur recevant le signal Oi et fournissant le signal OCompi. En variante, pour chaque sortie Oi, le circuit 404 est configuré pour fournir le signal complémentaire OCompi, par exemple au moyen d'un inverseur recevant le signal Oi et fournissant le signal OCompi.

Dans le mode de réalisation illustré, le circuit 700 comprend un circuit de routage configuré pour router le signal Oi vers la grille du transistor 800 et le signal OCompi vers la grille du transistor 806 lorsque le coefficient Ci est positif, et pour router le signal OCompi vers la grille du transistor 800 et le signal Oi vers la grille du transistor 806 lorsque le coefficient Ci est négatif. A titre d'exemple, le circuit de routage comprend deux multiplexeur MUX1 et MUX2 ayant chacun deux entrées configurées pour recevoir les signaux respectif Oi et OCompi, et une entrée de commande recevant un signal binaire SIGNP indiquant si le coefficient Ci est positif ou négatif. La sortie du multiplexeur MUX1, respectivement MUX2, est couplée à la grille du transistor 800, respectivement 806. A titre d'exemple, le signal SIGNP est fourni par un circuit de commande du circuit 404, par exemple par le circuit SEL.

Dans le mode de réalisation illustré, le filtre 400 est reconfigurable et le circuit 700 reçoit le signal SELi[m] correspondant, indiquant si le circuit 700 est sélectionné ou s'il est éteint. A titre d'exemple, le signal SELi[m] est un signal binaire à un niveau haut si le circuit 700 est sélectionné, et à un niveau bas sinon. A titre d'exemple, le circuit 700 comprend alors deux portes ET1 et ET2 mettant en oeuvre chacune la fonction booléenne ET. La porte ET1, respectivement ET2, a une première entrée connectée à la sortie du multiplexeur MUX1, respectivement MUX2, une deuxième entrée configurée pour recevoir le signal SELi[m], et une sortie couplée, de préférence connectée, à la grille du transistor 800, respectivement 806.

Dans un autre mode de réalisation non illustré, le filtre 400 n'est pas reconfigurable et les portes ET1 et ET2 sont omises, la sortie du multiplexeur MUX1, respectivement MUX2, étant alors, par exemple, directement connecté à la grille du transistor 800, respectivement 806.

Dans encore un autre mode de réalisation non illustré où le filtre 400 n'est pas reconfigurable, les portes ET1 et ET2 et les multiplexeurs MUX1 et MUX2 sont omis. La grille du transistor 800, respectivement 806, reçoit alors, par exemple, le signal Oi, respectivement OCompi, si le coefficient Ci correspondant est positif, et le signal OCompi, respectivement Oi, si le coefficient correspondant est négatif.

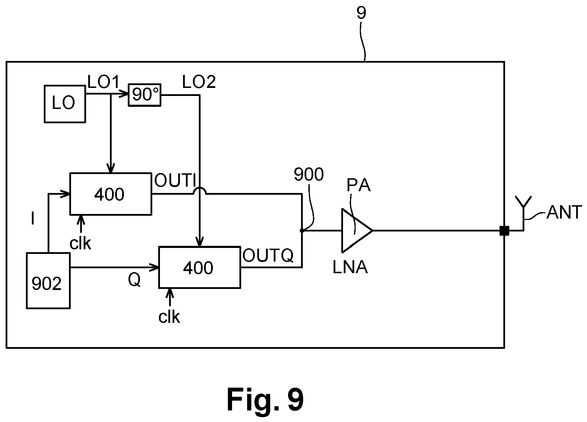

La figure 9 représente sous la forme de blocs un exemple de mode de réalisation d'un émetteur radiofréquence 9 comprenant le filtre 400. Toutefois, le filtre 400 peut être prévu dans d'autres émetteurs radiofréquences que celui décrit en relation avec la figure 9.

Dans cet exemple, l'émetteur 9 comprend deux filtres 400 mettant chacun en oeuvre une fonction de mixeur.

Les deux filtres 400 fournissent leurs signaux de sortie à un même noeud 900 de l'émetteur 9, le signal de sortie OUT d'un premier des deux circuits 400 étant référencé OUTI en figure 9 et le signal de sortie OUT du deuxième des deux circuits 400 étant référencé OUT2 en figure 9. Le noeud 900 est couplé à une antenne ANT de l'émetteur 9, dans cet exemple par un amplificateur de puissance radiofréquence PA.

Chacun des deux circuits 400 reçoit le signal clk de commande de son registre à décalage 402.

Le signal binaire de donnée reçu par le premier circuit 400, c'est à dire par l'entrée In de son registre à décalage 402, est un signal binaire I, et le signal binaire de donnée reçu par le deuxième circuit 400, c'est à dire par l'entrée In de son registre à décalage 402, est un signal binaire Q. Les deux signaux I et Q sont à la même fréquence Fdata. Les deux signaux I et Q définissent, par exemple, une modulation QPSK d'un signal à la fréquence Fdata. Les deux signaux I et Q sont par exemple fournis par un circuit 902 de l'émetteur 9.

L'émetteur 9 comprend en outre au moins un oscillateur local LO configuré pour fournir un signal périodique SIGLOI à la fréquence Fc, et un signal SIGLOQ à la même fréquence Fc mais en quadrature avec le signal SIGLOI.

Dans l'exemple illustré, l'émetteur 9 comprend un unique oscillateur LO fournissant le signal SIGLOI, et comprend en outre un circuit 904 (bloc "90°" en figure 9) configuré pour fournir le signal SIGLOQ à partir du signal SILOI. Dans un autre exemple non illustré, l'émetteur 9 comprend deux oscillateurs LO en quadrature l'un avec l'autre, un premier des deux oscillateurs fournissant le signal SIGLOI, et le deuxième des deux oscillateurs fournissant le signal SIGLOQ.

Le signal SIGLOI est fourni au premier des deux filtres 400 et correspond au signal SIGLO fournit à chacun des circuits 700 du circuit 404 du premier des deux filtres 400, et le signal SIGLOQ étant fourni au deuxième des deux filtres 400 et correspond au signal SIGLO fournit à chacun des circuits 700 du circuit 404 du deuxième des deux filtres 400. Par exemple, le signal SIGLOI est un signal différentiel comprenant une composant en phase SIGLOI+ correspondant au signal SIGLO+ reçu par les transistors 810 et 820 de chaque circuit 700 du premier filtre 400, et une composant en opposition de phase SIGLOI- correspondant au signal SIGLO-reçu par les transistors 814 et 818 de chaque circuit 700 du premier filtre 400, et, de manière similaire, le signal SIGLOQ est un signal différentiel comprenant une composant en phase SIGLOQ+ correspondant au signal SIGLO+ reçu par les transistors 810 et 820 de chaque circuit 700 du deuxième filtre 400, et une composant en opposition de phase SIGLOQ-correspondant au signal SIGLO- reçu par les transistors 814 et 818 de chaque circuit 700 du deuxième filtre 400.

Selon un mode de réalisation, la fréquence Fc est égale à 60 GHz, ou, dit autrement, l'émetteur 9 est configuré pour émettre dans la bande des 60 GHz.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, la personne du métier est en mesure d'adapter la description faite ci-dessus au cas où les niveaux correspondant aux états binaires respectifs '1' et '0' d'un signal binaire sont inversé par rapport à ce qui a été décrit et/ou au cas où la tension d'alimentation Vdd est négative par rapport à la tension de référence GND, qui est en pratique également une tension d'alimentation.

En outre, la personne du métier est mesure d'adapter la description faite ci-dessus à d'autres valeurs des entiers Q et/ou INT et/ou N et/ou min et/ou OSR et/ou à d'autres réponses impulsionnelles h(t). De préférence, lorsque le taux de suréchantillonnage OSR n'est pas égal à 4, ce dernier est égal à $2^n$, avec n entier strictement supérieur à 2. Toutefois, la solution proposée peut être mise en oeuvre avec OSR égal à 2, par exemple lorsqu'il n'est pas nécessaire de respecter les contraintes indiquées au début en ce qui concerne la puissance d'émission, et, dans ce cas, la solution proposée présente toujours une mise en oeuvre matériel plus simple et moins encombrante que la solution connue présentée en relation avec la figure 3.

Par ailleurs, la personne du métier sera en mesure de mettre en oeuvre les circuits 408 et 702 avec un unique réseau sommateur mettant en oeuvre, par exemple, une fonction d'adaptation d'impédance, ce réseau correspondant alors, par exemple, au circuit 702 décrit en relation avec la figure 8 auquel sont connectées les sorties 701 de tous les circuits 700 de tous les circuits 406i. Dit autrement, la personne du métier est en mesure de prévoir un unique circuit 702 commun à tous les circuits 404 et configuré pour fournir directement le signal OUT, ce circuit 702 unique correspondant alors au circuit 408 décrit en relation avec la figure 4, 5 ou 6.

Enfin, la mise en oeuvre pratique des modes de réalisation et variantes décrits est à la portée de la personne du métier à partir des indications fonctionnelles données ci-dessus.

En particulier, la personne du métier est en mesure de choisir les valeurs des entiers P et/ou N et/ou INT et/ou min lui permettant d'obtenir une réponse impulsionnelle du filtre 400 pour laquelle l'erreur avec une réponse impulsionnelle idéale h(t) reste inférieure à une erreur maximale cible.

En outre, la personne du métier est mesure de prévoir d'autres exemples de mises en oeuvre du circuit 404 et/ou des circuits 406i et/ou des circuits 700 et/ou du circuit 702 qui permette d'obtenir un dispositif 400 fonctionnant de la manière décrite en relation avec la figure 4, les mises en oeuvre des ces circuits n'étant pas limitées à celles décrites en relation avec les figures 7 et 8.

En outre, la personne du métier sera en mesure de mettre en oeuvre les circuits décrits, par exemple, au vu des fréquences des signaux considérés, les lignes de transmission permettant la propagation de ces signaux. Par exemple, la personne du métier sera en mesure de mettre en oeuvre les lignes de transmission permettant de distribuer les signaux SIGLO+ et SIGLO- aux circuits 406i et/ou 700.

**Revendications**

1. Emetteur radiofréquence (9) comprenant au moins un circuit de filtrage (400), ledit au moins un circuit de filtrage comprenant :

    un registre à décalage (402) série/parallèle comprenant une entrée binaire (In) et N sorties binaires Oi, avec N un entier supérieur ou égal à OSR, OSR un entier supérieur ou égal à 2, et i un indice entier allant de 0 à N-1, le registre à décalage (402) étant configuré pour recevoir un signal binaire de donnée (DATA ; I, Q) à une fréquence Fdata sur son entrée (In) et pour mettre en oeuvre des décalages sur ses sorties Oi à une fréquence égale à Fdata*OSR ;
    un premier circuit (404) défini par N coefficients Ci et configuré pour fournir, pour chaque coefficient Ci non nul, un signal SIGi analogique déterminé par ledit coefficient Ci et par un état binaire de la sortie Oi correspondante ; et
    un circuit sommateur (408, 502) configuré pour fournir un signal analogique de sortie (OUT ; OUTI, OUTQ) dudit circuit de filtrage égal à la somme des signaux analogiques SIGi.

2. Procédé mis en oeuvre dans un émetteur radiofréquence (9) comprenant au moins un circuit de filtrage (400), le procédé comprenant :

    recevoir un signal binaire de donnée (DATA ; I, Q) à une fréquence Fdata sur une entrée binaire (In) d'un registre à décalage (402) série/parallèle dudit au moins un circuit de filtrage (400), le registre à décalage (402) comprenant N sorties binaires Oi, avec N un entier supérieur ou égal à OSR, OSR un entier supérieur ou égal à 2 et i un indice entier allant de 0 à N-1 ;
    mettre en oeuvre avec le registre à décalage (402) des décalages de ses sorties Oi à une fréquence Fdata*OSR ;
    avec un premier circuit (404) dudit au moins un circuit de filtrage (400), ledit premier circuit (404) étant défini par N coefficients Ci, fournir, pour chaque coefficient Ci non nul, un signal SIGi déterminé par le coefficient Ci et un état binaire de la sortie Oi correspondante ; et
    fournir, avec un circuit sommateur (408 ; 502) dudit au moins un circuit de filtrage (400), un signal analogique de sortie (OUT ; OUTI, OUTQ) dudit circuit de filtrage égal à la somme des signaux analogiques SIGi.

3. Emetteur selon la revendication 1 ou procédé selon la revendication 2, dans lequel les coefficients Ci sont déterminés par une réponse impulsionnelle h(t) d'un filtre d'interpolation, de préférence de type à cosinus surélevés.

4. Emetteur selon la revendication 1 ou 3, ou procédé selon la revendication 2 ou 3, dans lequel :

    - pour i allant de 0 à N-1, chaque coefficient Ci est égal à un coefficient Dp d'indice p entier égal à i+min, min étant un entier positif ou nul ;
    - chaque coefficient Dp, avec p indice entier allant de 0 à P-1 et P un entier impair strictement supérieur à N, est calculé de manière récursive avec la formule suivante : $Dp = Bp - \sum_{j=p-OSR+1}^{j=p-1} Dj$, où j est un indice entier, Dj est nul si j est strictement négatif et est égal au coefficient Dp avec p = j sinon, et Bp est un coefficient d'indice p ; et
    - chaque coefficient Bp, avec p l'indice entier allant de 0 à P-1, est déterminé par la formule suivante : Bp = h((2*p-P+1)/(2*OSR)) où h(t) est normalisée et centrée sur t=0.

5. Emetteur selon l'une quelconque des revendications 1, 3 et 4, ou procédé selon l'une quelconque des revendications 2 à 4 dans lequel le registre à décalage (402) dudit au moins un circuit de filtrage (400) comprend N verrous synchrones (600) commandés par un signal d'horloge (clk) à une fréquence égale à Fdata*OSR/2, les N verrous étant connectés en série en alternant les verrous actifs sur un premier niveau du signal d'horloge (clk) et les verrous actifs sur un deuxième niveau du signal d'horloge (clk), les sorties Oi correspondant aux sorties (Q) des N verrous.

6. Emetteur ou procédé selon la revendication 5, dans lequel le registre à décalage (402) dudit au moins un circuit de filtrage (400) comprend en outre une bascule synchrone de type D ayant une entrée de donnée (D) couplée, de préférence connectée, à l'entrée série (In) dudit registre à décalage, une entrée de synchronisation configurée pour recevoir le signal d'horloge (clk), et une sortie (Q) connectée à une entrée de donnée (D) du premier desdits N verrous (600) connectés en série.

7. Emetteur selon l'une quelconque des revendications 1, 3 et 4, ou procédé selon l'une quelconque des revendications 2 à 4, dans lequel le registre à décalage (402) dudit au moins un circuit de filtrage (400) comprend N bascules synchrones (500) de type D commandées par un signal d'horloge (clk) à une fréquence égale à Fdata*OSR, les N bascules (500) étant connectées en série, et les sorties Oi correspondant aux sorties (Q) des N bascules.

8. Emetteur selon l'une quelconque des revendications 1, 3 et 4, ou procédé selon l'une quelconque des revendications 2 à 4, dans lequel le registre à décalage (402) dudit au moins un circuit de filtrage (400) comprend N bascules synchrones de type D commandées par un signal d'horloge à une fréquence égale à Fdata*OSR/2, les N bascules synchrones étant connectées en série en alternant les bascules (600) actives sur les fronts montants du signal d'horloge (clk) et les bascules (600) actives sur les fronts descendants du signal d'horloge (clk), et les sorties Oi correspondant aux sorties (Q) des N bascules.

9. Emetteur selon l'une quelconque des revendications 1 et 3 à 8, ou procédé selon l'une quelconque des revendications 2 à 8, dans lequel, pour chaque coefficient Ci non nul :

le premier circuit (404) dudit au moins un circuit de filtrage (400) comprend un nombre Ki de circuits élémentaires identiques (700) ayant chacun une sortie (701) configurée pour fournir :

- un signal analogique S0 lorsque la sortie correspondante Oi est dans un premier état binaire et que le coefficient Ci est positif, - un signal S1 complémentaire du signal S0 lorsque la sortie correspondante Oi est dans un deuxième état binaire et que le coefficient Ci est positif,
- le signal S1 lorsque la sortie correspondante Oi est dans le premier état binaire et que le coefficient Ci est négatif, et
- le signal S0 lorsque la sortie correspondante Oi est dans le deuxième état binaire et que le coefficient Ci est négatif ; et

le nombre Ki est égal la valeur absolue de l'arrondi à une valeur entière du produit du coefficient Ci par un entier INT identique pour tous les coefficients Ci.

10. Emetteur ou procédé selon la revendication 9, dans lequel, le premier circuit (404) dudit au moins un circuit de filtrage (400) comprend une pluralité de circuits élémentaires identiques (700) pour chaque coefficient Ci, le premier circuit (404) comprenant en outre un circuit de sélection (SEL) configuré pour sélectionner, pour chaque coefficient Ci, Ki circuits élémentaires (700) parmi ladite pluralité de circuits élémentaires (700) et pour éteindre les circuits élémentaires non sélectionnés, Ki étant nul pour les coefficients Ci nuls.

11. Emetteur ou procédé selon la revendication 9 ou 10, dans lequel chaque circuit élémentaire (700) reçoit un même signal périodique (SIGLO ; SIGLO+, SIGLO- ; SIGLOI, SIGLOQ) et est configuré pour que le signal S0 soit en phase avec ce signal périodique et à la même fréquence que ce signal périodique.

12. Emetteur ou procédé selon la revendication 11, dans lequel :

la sortie (701) de chaque circuit élémentaire (700) comprend un premier noeud de sortie (7012) et un deuxième noeud de sortie (7011) ;
chaque circuit élémentaire comprend :

- un premier transistor MOS (800) couplant un noeud de référence (802) à un premier noeud interne (804),
- un deuxième transistor MOS (806) couplant le noeud de référence (802) à un deuxième noeud interne (808),
- un troisième transistor MOS (810) couplant le premier noeud interne (804) au premier noeud de sortie (7012) et ayant une grille configurée pour recevoir ledit signal périodique (SIGLO ; SIGLO+),
- un quatrième transistor MOS (814) couplant le premier noeud interne (804) au deuxième noeud de sortie (7011) et ayant une grille configurée pour recevoir un signal (SIGLO-) en opposition de phase avec le signal périodique (SIGLO ; SIGLO+),
- un cinquième transistor MOS (818) couplant le deuxième noeud interne (808) au premier noeud de sortie (7012) et ayant une grille configurée pour recevoir le signal (SIGLO-) en opposition de phase, et
- un sixième transistor MOS (820) couplant le deuxième noeud interne (808) au deuxième noeud de sortie (7011) et ayant une grille configurée pour recevoir le signal périodique (SIGLO ; SIGLO+) ; et

pour chaque coefficient Ci non nul et pour chacun des Ki circuits élémentaires (700) de ce coefficient Ci, les premier et deuxième transistors (800, 802) sont commandés à partir de la sortie correspondante Oi, en en opposition de phase l'un par rapport à l'autre.

13. Emetteur selon l'une quelconque des revendications 1 et 3 à 12, ou procédé selon l'une quelconque des revendications 2 à 12, dans lequel :

l'émetteur (9) comprend deux circuits de filtrage (400) configurés pour fournir leurs signaux de sortie (OUT ; OUTI, OUTQ) à un même noeud (900) couplé à une antenne (ANT) de l'émetteur (9) ;
l'entrée (In) du registre à décalage (402) d'un premier des deux circuits de filtrage (400) reçoit un premier signal binaire de donnée (I) à la fréquence Fdata ; et
l'entrée (In) du registre à décalage (402) d'un deuxième des deux circuits reçoit un deuxième signal binaire de donnée (Q) à la fréquence Fdata.

14. Emetteur ou procédé selon la revendication 13 prise dans sa dépendance à la revendication 11 ou 12, dans lequel :

l'émetteur (9) comprend au moins un oscillateur local (LO) configuré pour fournir un premier signal périodique (LO1) et un deuxième signal périodique (LO2) en quadrature avec le premier signal périodique (LO1) ;
ledit même signal périodique reçu par les circuits élémentaires (700) du premier circuit de filtrage (400) est le premier signal périodique (LO1) ; et
ledit même signal périodique reçu par les circuits élémentaires (700) du deuxième circuit de filtrage (400) est le deuxième signal périodique (LO2).

15. Emetteur selon l'une quelconque des revendications 1 et 3 à 14 ou procédé selon l'une quelconque des revendications 2 à 14, dans lequel l'émetteur est configuré pour émettre dans la bande des 60 GHz.

Fig. 1

Fig. 2

Fig. 3

Fig. 4

Fig. 5

**Fig. 6**

EP 4 383 566 A1

SIGi

404

SEL

702

406i

SELi[0..Q-1]

SELi[0] SELi[1] SELi[2] SELi[3] SELi[4] SELi[5] SELi[6] SELi[7]

701 701 701 701 701 701 701 701

SIGLO · · ·

700 700 700 700 700 700 700 700

· · ·

Oi

# Fig. 7

702

L3    800

GND

812

L1

816

L2

VDD

822    824

7012

7011

810

818

SIGLO+

814

820

SIGLO+

SIGLO-

804

808

800

806

GND

802

GND

802

700

ET1

ET2

SELi[m]

SIGNP

SIGNP

MUX2

MUX1

OCompi

OCompi

Oi

# Fig. 8

**Fig. 9**

Europäisches
Patentamt

European
Patent Office

Office européen
des brevets

**RAPPORT DE RECHERCHE EUROPEENNE**

Numéro de la demande

**EP 23 20 9358**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | GEBREYOHANNES FIKRE TSIGABU ET AL: "A Configurable Transmitter Architecture for IEEE 802.11ac and 802.11ad Standards", IEEE TRANSACTIONS ON CIRCUITS AND SYSTEMS II: EXPRESS BRIEFS, IEEE, USA, vol. 63, no. 1, 1 janvier 2016 (2016-01-01), pages 9-13, XP011596250, ISSN: 1549-7747, DOI: 10.1109/TCSII.2015.2468920 [extrait le 2015-12-22] | 1-8, 13-15 | INV. H03H17/02 H03H17/06 ADD. H03H17/00 |
| A | * abrégé; figures 1, 2, 6,9 * | 9-12 | |
| X | KAISER ANDREAS ET AL: "Digital RF transmitter architectures exploiting FIRDACs in various configurations", 2017 IEEE 12TH INTERNATIONAL CONFERENCE ON ASIC (ASICON), IEEE, 25 octobre 2017 (2017-10-25), pages 1094-1097, XP033295121, DOI: 10.1109/ASICON.2017.8252670 | 1,2,4-8, 13-15 | |
| A | * abrégé; figures 3, 4, 5 * | 9-12 | DOMAINES TECHNIQUES RECHERCHES (IPC) H03H |
| X | US 5 710 729 A (DALLE FESTE SANDRO [IT] ET AL) 20 janvier 1998 (1998-01-20) | 1,2,4-8 | |
| A | * colonne 2, ligne 48 – ligne 56; figures 4, 6 * | 9-12 | |
| A | DE 102 36 328 A1 (KONINKL PHILIPS ELECTRONICS NV [NL]) 19 février 2004 (2004-02-19) * figures 1-4 * | 1-15 | |

Le présent rapport a été établi pour toutes les revendications

| Lieu de la recherche | Date d'achèvement de la recherche | Examinateur |
|---|---|---|
| Munich | 25 avril 2024 | Naumann, Olaf |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

**EP 4 383 566 A1**

## ANNEXE AU RAPPORT DE RECHERCHE EUROPEENNE
## RELATIF A LA DEMANDE DE BREVET EUROPEEN NO.

EP 23 20 9358

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-04-2024

| Document brevet cité au rapport de recherche | | Date de publication | Membre(s) de la famille de brevet(s) | | Date de publication |
|---|---|---|---|---|---|
| US 5710729 | A | 20-01-1998 | EP | 0690566 A1 | 03-01-1996 |
| | | | JP | H0846487 A | 16-02-1996 |
| | | | US | 5710729 A | 20-01-1998 |
| DE 10236328 | A1 | 19-02-2004 | AU | 2003249502 A1 | 25-02-2004 |
| | | | CN | 1675719 A | 28-09-2005 |
| | | | DE | 10236328 A1 | 19-02-2004 |
| | | | EP | 1529292 A1 | 11-05-2005 |
| | | | JP | 2005535991 A | 24-11-2005 |
| | | | WO | 2004015715 A1 | 19-02-2004 |

EPO FORM P0460